# EUROPÄISCHE PATENTSCHRIFT

(11) **EP 0 799 406 B1**
(45) Veröffentlichungstag und Bekanntmachung des Hinweises auf die Patenterteilung: **23.02.2000**
(21) Anmeldenummer: 95936981.0
(22) Anmeldetag: 25.11.1995
(51) Int. Cl.: G01D 11/28, G01R 1/08, B60Q 3/04, G12B 11/00

(54) **ANZEIGEINSTRUMENT**
INDICATOR
INDICATEUR

(30) Priorität: 20.12.1994 DE 4445482; 22.04.1995 DE 19514902
(43) Veröffentlichungstag der Anmeldung: 08.10.1997
(73) Patentinhaber: ROBERT BOSCH GMBH, 70442 Stuttgart (DE)
(72) Erfinder: HERSEL, Walter, D-72827 Wannweil (DE); MUELLER-SYBRICHS, Ralf, D-71254 Ditzingen (DE); OREANS, Derk, D-71229 Leonberg (DE); FRIEDL, Bernhard, D-71272 Renningen (DE)
(74) Vertreter: Friedmann, Jürgen
(86) Internationale Anmeldenummer: DE9501664
(87) Internationale Veröffentlichungsnummer: WO9619713

(56) Entgegenhaltungen:
- DE-A- 4 023 693
- DE-A- 4 319 441

## Beschreibung

### Stand der Technik

Die Erfindung geht aus von einem Anzeigeinstrument nach dem Oberbegriff des Hauptanspruchs. Aus der DE-OS 29 13 139 ist eine beleuchtete Meßanzeige bekannt. Auf einer lichtleitenden Scheibe ist dabei ein Zifferblatt aufgebracht, über dem ein gleichfalls beleuchtbarer Zeiger drehbar angebracht ist. Mittels einer Lampe wird Licht in die lichtleitende Scheibe eingekoppelt. Das Licht fällt aus der lichtleitenden Scheibe durch das Zifferblatt zu einem Betrachter und dient somit zur Beleuchtung des Zifferblattes.

Die Merkmale des Oberbegriffs des Hauptanspruchs sind aus den Schriften DE-A-4 023 693 und DE-A-4 319 441 bekannt.

### Vorteile der Erfindung

Das Anzeigeelement mit den kennzeichnenden Merkmalen des Hauptanspruchs hat demgegenüber den Vorteil, daß sich die Bautiefe des Anzeigeinstruments aufgrund der flachen Bauweise von Elektrolumineszenzanzeigen vorteilhaft verringert. Außerdem ist dieses Anzeigeinstrument besonders stromsparend, da die Lichtausbeute der Elektrolumineszenzanzeige relativ hoch ist. Das erfindungsgemäße Anzeigeinstrument ist zudem besonders preiswert herstellbar, da auch kein optisch transparentes Material als Lichtleiter benötigt wird.

Durch die in den Unteransprüchen aufgeführten Maßnahmen sind Verbesserungen und Weiterbildungen des im Hauptanspruch angegebenen Anzeigeinstruments möglich.

Leiterbahnen auf der Rückseite der Trägerplatte dienen in vorteilhafter Weise der Verbindung der elektrischen Bauelemente zu einer elektrischen Schaltung. Zudem sind Leiterbahnen sehr einfach durch bekannte Verfahren, wie beispielsweise Photolithographie oder Siebdruck auf der Trägerplatte herstellbar.

Die Elektrolumineszenzanzeige ist als fertige Anzeige, insbesondere, wie sie im Handel erhältlich ist, auf die Trägerplatte aufklebbar, aber auch besonders platzsparend und aufwandsarm herstellbar, indem die einzelnen Komponenten für die Elektrolumineszenzanzeige auf die Trägerplatte gedruckt werden.

Eine Verbindung der Elektrolumineszenzanzeige mit den elektrischen Bauelementen auf der Rückseite der Trägerplatte ist mittels Durchkontaktierungen auf sehr platzsparende Weise und mit einem um einen Rand der Trägerplatte herum verlaufenden Kontaktelement auf sehr aufwandsarme Weise möglich.

Dadurch, daß eine elektrolumineszente Schicht zusammen mit einer strukturierten, elektrisch leitfähigen Schicht auf einer gemeinsamen Trägerschicht aufgebracht ist, die von der Vorderseite der Trägerplatte zur Rückseite der Trägerplatte geführt ist, ist die Elektrolumineszenzanzeige besondes einfach herstellbar und gleichzeitig besonders einfach ansteuerbar, insbesondere da die elektrisch leitfähige Schicht auf der Rückseite der Trägerplatte zur Zuführung von Signalen zur Ansteuerung der elektrolumineszenten Schicht dienen kann.

Wenn die elektrisch leitfähige Schicht auf der Rückseite der Trägerplatte mit elektrischen Bauelementen bestückt ist, so entsteht der Vorteil, daß die elektrisch leitfähige Schicht gleichzeitig die Zuleitungskontakte für die elektrolumineszente Schicht umfassen kann und als Leiterbahnen aufweisende Schicht für eine elektrische Schaltung dienen kann.

Das Anzeigeinstrument ist besonders einfach herstellbar, wenn die Trägerschicht mit wenigstens der darauf aufgebrachten elektrisch leitfähigen Schicht flexibel ist, da die Trägerschicht mit der elektrolumineszenten Schicht und der elektrisch leitfähigen Schicht zunächst auf einer planen Oberfläche der flexiblen Trägerschicht herstellbar ist und anschließend ein einfaches Umbiegen der Trägerschicht mit wenigstens der elektrisch leitfähigen Schicht um die Trägerplatte dazu dienen kann, die Vorderseite und die Rückseite der Trägerplatte entsprechend mit der Trägerschicht zu verbinden.

Ein Klebevorgang für die Befestigung der Trägerschicht auf der Trägerplatte erweist sich als besonders kostensparend.

Dies gilt ebenso für die Befestigung des Zifferblattes auf der elektrolumineszenten Schicht.

Das Anzeigeinstrument ist besonders dafür geeignet, mit einem Zeigerantriebswerk und einem davon angetriebenen Zeiger kombiniert zu werden, indem eine Aussparung in der Trägerplatte für die Durchführung der Welle des Zeigerantriebswerkes dient, da es herstellungstechnisch besonders einfach ist, in der Anordnung aus Trägerplatte und Elektrolumineszenzanzeige eine Aussparung anzuordnen.

Umfaßt das Zeigerantriebswerk einen Schrittmotor, so vermindert sich wiederum die Bautiefe des Anzeigeinstruments.

### Zeichnung

Ausführungsbeispiele der Erfindung sind in der Zeichnung dargestellt und in der nachfolgenden Beschreibung näher erläutert. Es zeigen:
Figur 1: eine aufgeschnittene Seitenansicht eines Anzeigeinstruments mit einer Elektrolumineszenzanzeige mit einer Trägerschicht,
Figur 2: eine aufgeschnittene Seitenansicht eines Anzeigeinstruments mit einer Elektrolumineszenzanzeige ohne Trägerschicht,

### Beschreibung der Ausführungsbeispiele

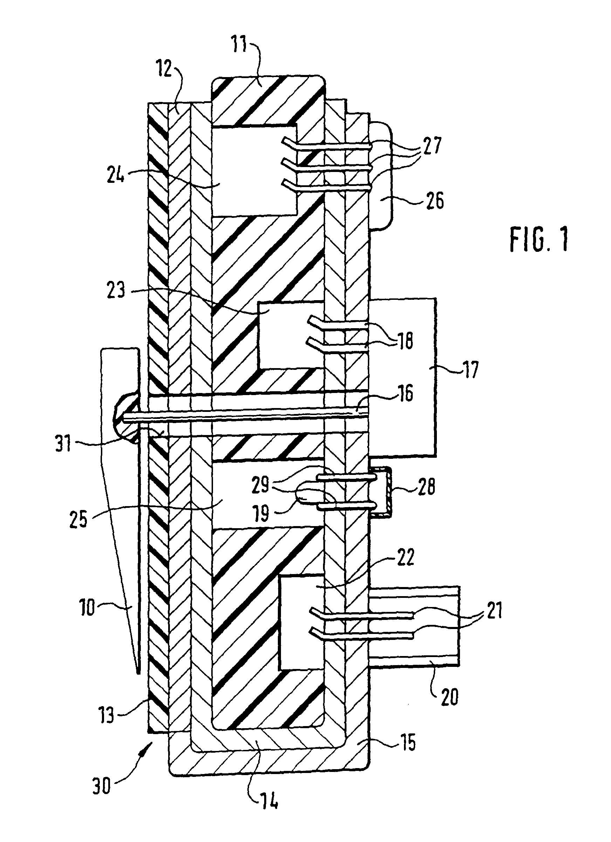

Figur 1 zeigt einen Querschnitt durch eine flache Trägerplatte 11, die an ihrer Vorderseite eine Vertiefung 24 und an ihrer Rückseite zwei Vertiefungen 22, 23 aufweist. Um die Trägerplatte 11 ist eine Trägerschicht 14 derart herumgefaltet, daß die Trägerschicht 14 die Vorderseite, die Rückseite und die diese beiden Seiten verbindende Unterseite der Trägerplatte 11 bedeckt. Der auf der Vorderseite der Trägerplatte 11 liegende Anteil der Trägerschicht 14 ist mit einer elektrolumineszenten Schicht 12 bedeckt. Die restliche Fläche der Trägerschicht 14 ist mit einer elektrisch leitfähigen, strukturierten Schicht 15 bedeckt. Die elektrisch leitfähige Schicht 15 ist dabei so strukturiert, daß sie einzelne, voneinander elektrisch isolierte Leiterbahnen umfaßt, die zum einen zur Kontaktierung der elektrolumineszenten Schicht 12 und zum anderen zur Kontaktierung von elektrischen Bauelementen 19, 20, 26 dienen. Das auf dem auf der Rückseite der Trägerplatte 11 liegenden Anteil der elektrisch leitfähigen, strukturierten Schicht 15 liegende elektrische Bauelement 26 ist hier in Form eines integrierten Schaltkreises ausgebildet, dessen Anschlüsse 27 durch die elektrisch leitfähige Schicht 15, die Trägerschicht 14 und Löcher in der Trägerplatte 11 in die Vertiefung 24 in der Rückseite der Trägerplatte 11 ragen. Das auf dem auf der Rückseite der Trägerplatte 11 liegenden Anteil der elektrisch leitfähigen, strukturierten Schicht 15 angeordnete elektrische Bauelement 20 ist beispielhaft als Steckvorrichtung ausgebildet, deren Steckkontakte 21 durch die elektrisch leitfähige Schicht 15 und die Trägerschicht 14 in die Vertiefung 22 ragen. Die Trägerplatte 11 weist zudem einen Durchbruch 25 auf, der sich von der Rückseite zur Vorderseite erstreckt, und in dem das als Leuchtdiode mit Leuchtdiodenanschlußkontakten 29 ausgebildete elektrische Bauelement 19 so angeordnet ist, daß dessen Licht durch die Durchführung 25 in Richtung zur Vorderseite abgestrahlt wird. Die Leuchtdiode 19 ist mit den Leuchtdiodenanschlußkontakten 29 in der Trägerschicht 14 und der elektrisch leitfähigen Schicht 15 verankert, wobei die Leuchtdiodenanschlußkontakte 29 aus dem Durchbruch 25 durch die Trägerschicht 14 und die elektrisch leitfähige Schicht 15 zur Rückseite ragen. Die Leuchtdiodenanschlußkontakte 29 sind auf der Rückseite mit einer isolierenden Schutzkappe 28 überdeckt. Die Anschlüsse 27 und die Steckkontakte 21 sind innerhalb der Vertiefungen 22, 24 umgebogen, so daß dadurch die zugehörigen elektrischen Bauelemente 20, 26 gegen Herausfallen gesichert sind. Zusätzlich sind die Anschlüsse 27, die Leuchtdiodenanschlußkontakte 29 und die Steckkontakte 21 beispielsweise durch Löten mit einigen Leiterbahnen der elektrisch leitfähigen Schicht 15 elektrisch verbunden. Auf der elektrolumineszenten Schicht 12 ist ein Zifferblatt 13 aufgeklebt. Auf der Rückseite der Trägerplatte 11 ist auf der elektrisch leitfähigen Schicht 15 außerdem ein Zeigerantriebswerk 17 in Form eines Schrittmotors angeordnet, der eine Welle 16 aufweist, die durch eine Aussparung 31, welche sich durch das Zifferblatt 13, die elektrolumineszente Schicht 12, die Trägerschicht 14, die Trägerplatte 11, wiederum die Trägerschicht 14 und erneut die elektrisch leitfähige Schicht 15 hindurch erstreckt. Die Welle 16 tritt auf der Vorderseite am Zifferblatt 13 aus der Aussparung 31 aus und dient dort der Halterung eines drehbar angetriebenen Zeigers 10. Zur Zuführung von Strom weist der Schrittmotor 17 Motorkontakte 18 auf, die ebenfalls mit einigen Leiterbahnen der elektrisch leitfähigen Schicht 15 elektrisch, beispielsweise durch Löten, verbunden sind und die durch die Trägerschicht 14 in die Vertiefung 23 ragen, wo sie durch Abknicken, d.h. Verbiegen gegen Herausrutschen gesichert sind und somit eine mechanische Befestigung des Schrittmotors 18 bewirken.

Die Trägerschicht 14 ist vorzugsweise aus einem flexiblen Material herstellbar. Die elektrolumineszente Schicht 12 ist zum Beispiel auf die Trägerschicht 14 aufgeklebt und elektrisch mit einigen Leiterbahnen der auf der Trägerschicht 14 aufgedruckten elektrisch leitfähigen Schicht 15 verbunden. Die elektrisch leitfähige Schicht 15 ist dabei so strukturiert, daß eine Zuführung von Strom über durch die Strukturierung entstandene Leiterbahnen zur elektrolumineszenten Schicht 12 möglich ist. Die elektrisch leitfähige Schicht 15 ist außerdem weiter auf der Trägerschicht 14 so strukturiert, daß Leiterbahnen entstanden sind, auf die in einem späteren Schritt elektrische Bauelemente aufsetzbar sind. Da die Trägerschicht 14 mit der elektrisch leitfähigen Schicht 15 und der elektrolumineszenten Schicht 12 flexibel ist, ist sie als plane Mehrschichtanordnung herstellbar und anschließend durch einfaches Herumfalten um die Trägerplatte 11 auf diese aufbringbar. Durch Zwischengabe eines Klebstoffes läßt sich diese Mehrschichtanordnung auf der Trägerplatte 11 fixieren. Die elektrisch leitfähige Schicht 15 ist durch ihre Strukturierung in Leiterbahnen auf der Rückseite der Trägerplatte 11 mit den elektrischen Bauelementen 19, 26, 20 bestückt, so daß eine elektrische Schaltung mit gedruckten Leiterbahnen und diskreten Bauelementen entstanden ist. Die elektrischen Bauelemente 20, 26 sind dabei durch Umknicken der Kontakte 21 bzw. Anschlüsse 27 hinter der Trägerschicht 14 oder auch der Trägerplatte 11 auch noch zusätzlich mechanisch stabil verankert. Dieses Umknicken kann zum Teil bereits vor dem Umfalten der Mehrschichtanordnung um die Trägerplatte 11 erfolgen. Somit ist die elektrische Schaltung auf der Rückseite der Trägerplatte 11, zur Ansteuerung der elektrolumineszenten Schicht 12 auf der Vorderseite der Trägerplatte 11 zusammen mit der elektrolumineszenten Schicht 12 auf der gemeinsamen Trägerschicht 14 integrierbar. Zusätzlich ist auch noch der Schrittmotor 17 auf der elektrisch leitfähigen Schicht 15 angebracht, wobei die Leiterbahnen der elektrisch leitfähigen Schicht 15 auch zur Zuführung des Stromes für den Schrittmotor 17 dienen. Somit läßt sich auch die Ansteuerungselektronik für den Schrittmotor 17 auf der Trägerschicht 14 mit der elektrisch leitfähigen Schicht 15 mit integrieren. Durch die fertige Anordnung aus Zifferblatt 13, elektrolumineszenter Schicht 12, Trägerschicht 14, Trägerplatte 11 und bestückter elektrisch leitfähiger Schicht 15 wurde außerdem ein Loch gebohrt, welches als die Aussparung 31 für die Durchführung der Welle 16 vom Schrittmotor 17 zur Vorderseite des Zifferblatts 13 dient. Das Loch kann aber ebenso in die Trägerplatte 11 und in die Mehrschichtanordnung je einzeln eingebracht werden, so daß sich diese Löcher nach dem Befestigen der Mehrschichtanordnung auf der Trägerplatte 11 zur Aussparung 31 ergänzen. Somit ist über die strukturierte elektrisch leitfähige Schicht 15 und die elektrischen Bauelemente 19, 20, 26 sowohl Strom für die Erzeugung von Licht mittels der elektrolumineszenten Schicht 12 als auch Strom zur Ansteuerung des Schrittmotors 17 zuleitbar. Das Anzeigeinstrument vereinigt somit Beleuchtung, Zeigerantrieb und die zugehörigen elektrischen Schaltungen und eventuell auch noch weitere elektronische Schaltungen auf einer flexiblen Trägerschicht 14, wodurch sich Baugröße und Herstellungsaufwand vorteilhaft minimieren. Eine separate Leiterplatte ist daher nicht mehr nötig.

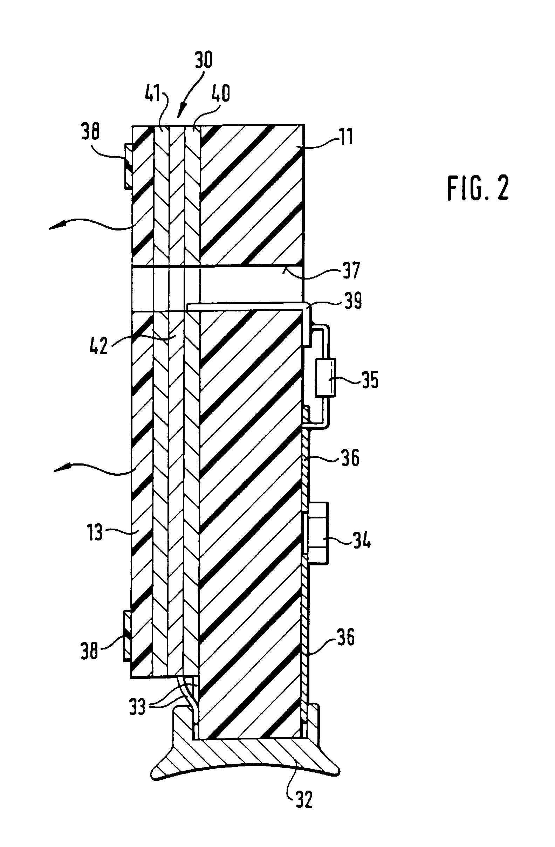

In Figur 2 ist ein weiteres Ausführungsbeispiel des erfindungsgemäßen Anzeigeinstruments dargestellt, wobei gleiche Ziffern gleiche Elemente bezeichnen wie in Figur 1. Die Trägerplatte 11 weist an ihrer Rückseite mehrere Leiterbahnen 36 auf, an die elektrische Bauelemente 34, 35 angeschlossen sind. Als Bauelement 34 wurde beispielsweise ein SMD-Bauelement verwendet und als weiteres Bauelement 35 ein Bauelement mit Drahtanschlüssen. Auf der Vorderseite weist die Trägerplatte 11 die Elektrolumineszenzanzeige 30 auf, die zwei elektrisch leitfähige Schichten 40, 41 und dazwischen angeordnet eine lumineszierende Schicht 42 aufweist. Zum Anschluß der beiden elektrisch leitfähigen Schichten 41, 40 sind elektrische Kontakte 33 vorgesehen, die an einem Rand der Trägerplatte 11 aus der Elektrolumineszenzanzeige 30 herausragen. Des weiteren ist ein Kontaktelement 32 vorgesehen, das in Form einer Klammer ausgebildet ist, wobei die Klammer 32 mehrere voneinander elektrisch isolierte leitfähige Verbindungswege aufweist, die in der Zeichnung nicht im Detail dargestellt sind, und die zur Verbindung der Kontakte 33 mit den Leiterbahnen 36 auf der Rückseite der Trägerplatte 11 dienen. Auf der Oberfläche der Elektrolumineszenzanzeige 30 sind auf das Zifferblatt 13 mehrere Ziffern 38 aufgebracht. Die Elektrolumineszenzanzeige 30 weist in diesem Beispiel zwei unabhängig voneinander schaltbare Anzeigebereiche auf. Zur Kontaktierung des zweiten Anzeigebereichs ist beispielhaft eine Aussparung 37 in der Trägerplatte 11 vorgesehen, durch die eine Durchkontaktierung 39 von der Rückseite der Trägerplatte 11 zu der Stelle ragt, wo die Kontaktierung mit dem zweiten Anzeigebereich an einer der beiden elektrisch leitfähigen Schichten 41, 40 erwünscht ist.

In dieser Ausführungsform befindet sich die Schaltung zur Ansteuerung der auf der Vorderseite der Trägerplatte 11 angeordneten Elektrolumineszenzanzeige 30 auf der gegenüberliegenden Rückseite, und zwar in Form einer direkt auf der Trägerplatte 11 aufgebrachten elektrischen Schaltung. Diese elektrische Schaltung mit den Leiterbahnen 36 und den elektrischen Bauelementen 34, 35 ist vorzugsweise durch ein photolithografisches Verfahren oder ein Siebdruckverfahren mit nachfolgender Bestückung hergestellt worden. Die Trägerplatte 11 dient somit als Leiterplatte. Bei diesem Verfahrensschritt können ebenso bereits die Aussparung 37 und Durchkontaktierung 39 hergestellt werden. Für die Kontakte 33, die sich am Rand der Trägerplatte 11 befinden, dient das Kontaktelement 32 als Verbindungsmittel zur elektrischen Schaltung. Dabei wohnt dem Kontaktelement 32 eine federnde Wirkung inne, die ein Aufschieben auf die Trägerplatte 11 und ein dortiges mechanisch festes Verbleiben sicherstellt. Die Elektrolumineszenzanzeige 30 kann wahlweise in einem fertigen Zustand, d.h. als handelsüblich erwerbbares Schichtenpaket verwendet werden, indem sie auf die Trägerplatte 11 aufgeklebt wird. Alternativ dazu kann auch ein Druckverfahren verwendet werden, indem auf die in diesem Fall auf der Vorderseite bereits die elektrisch leitfähige Schicht 40 aufweisende Trägerplatte 11 die lumineszierende Schicht 42 und anschließend die elektrisch leitfähige Schicht 41 aufgetragen werden. Das Zifferblatt 13 kann ebenfalls sowohl durch Kleben aufgebracht werden, als auch durch ein Druckverfahren unmittelbar auf der Oberfläche der Elektrolumineszenzanzeige 30 hergestellt werden. Die Aussparung 37 ist ebenso hier als Durchführung für die Welle 16 eines Schrittmotors 17 geeignet, wie in Figur 1 dargestellt. Auch für diese Anordnung ist somit eine separate Leiterplatte für die zur Elektrolumineszenzanzeige 30 zugehörige Schaltung nicht mehr nötig, und es ist nicht nur die Schaltung zur Ansteuerung der Elektrolumineszenzanzeige 30 auf der Rückseite der Trägerplatte 11 anordenbar, sondern auch eine eventuell notwendige Schaltung zur Ansteuerung eines eventuell vorhandenen Schrittmotors 17 oder für sonstige Funktionen.

Es sind selbstverständlich mehrere Anzeigebereiche vorsehbar, die auch verschiedene Farben aufweisen können. Die Anschlüsse zwischen diesen Anzeigebereichen und der Schaltung auf der Rückseite der Trägerplatte 11 können mittels Durchkontaktierungen ebenso wie mittels um den Rand der Trägerplatte 11 verlaufende Kontaktmittel erfolgen. Zudem kann die Klammer 32 auch durch eine andere elektrische Verbindungsform, wie Kabel oder Stecker etc. realisiert sein. Die verschiedenen Ausführungen der beiden Ausführungsbeispiele sind auch ganz oder teilweise miteinander kombinierbar.

## Patentansprüche

1. Anzeigeinstrument, insbesondere für ein Kraftfahrzeug, mit einem beleuchtbaren, teilweise transparenten Zifferblatt (13), das auf der Vorderseite einer Trägerplatte (11) angeordnet ist, daß zwischen dem Zifferblatt (13) und der Trägerplatte (11) auf der Trägerplatte (11) eine Elektrolumineszenzanzeige (30) angeordnet ist, die mit auf der Rückseite der Trägerplatte (11) angeordneten elektrischen Bauelementen (26, 19, 20, 34, 35) verbunden ist, dadurch gekennzeichnet, daß die Elektrolumineszenzanzeige (30) eine elektrolumineszente Schicht (12) umfaßt, die zusammen mit einer elektrisch leitfähigen Schicht (15) auf einer gemeinsamen Trägerschicht (14) aufgebracht ist, und daß die Trägerschicht (14) mit wenigstens der darauf aufgebrachten elektrisch leitfähigen Schicht (15) von der Vorderseite der Trägerplatte (11) zur Rückseite der Trägerplatte (11) geführt ist.

2. Anzeigeinstrument nach Anspruch 1, dadurch gekennzeichnet, daß die Trägerplatte (11) auf der Rückseite Leiterbahnen aufweist, die mit den elektrischen Bauelementen (34, 35) bestückt sind.

3. Anzeigeinstrument nach Anspruch 1 oder 2, dadurch gekennzeichnet, daß die Elektrolumineszenzanzeige (30) auf die Trägerplatte (11) geklebt ist.

4. Anzeigeinstrument nach Anspruch 1 oder 2, dadurch gekennzeichnet, daß die Elektrolumineszenzanzeige (30) auf die Trägerplatte (11) gedruckt ist.

5. Anzeigeinstrument nach einem der Ansprüche 1 bis 4, dadurch gekennzeichnet, daß die Elektrolumineszenzanzeige (30) über Durchführungskontakte und/oder ein um einen Rand der Trägerplatte (11) herum verlaufendes Kontaktelement (32) mit den Bauelementen (26, 19, 20, 34, 35) verbunden ist.

6. Anzeigeinstrument nach Anspruch 1, dadurch gekennzeichnet, daß die elektrisch leitfähige Schicht (15) auf der Rückseite der Trägerplatte (11) mit elektrischen Bauelementen (26, 19, 20) bestückt ist.

7. Anzeigeinstrument nach einem der Ansprüche 1 bis 6, dadurch gekennzeichnet, daß die Trägerschicht (14) mit wenigstens der darauf aufgebrachten elektrisch leitfähigen Schicht (15) flexibel ist.

8. Anzeigeinstrument nach einem der vorherigen Ansprüche, dadurch gekennzeichnet, daß die Trägerschicht (14) auf die Trägerplatte (11) geklebt ist.

9. Anzeigeinstrument nach einem der Ansprüche 1 bis 8, dadurch gekennzeichnet, daß das Zifferblatt (13) auf die Elektrolumineszenzanzeige (30) geklebt ist.

## Claims

1. Indicating instrument, in particular for a motor vehicle, having a partially transparent dial (13) which can be illuminated and is arranged on the front side of a carrier plate (11), there being arranged between the dial (13) and the carrier plate (11) on the carrier plate (11) an electroluminescent display (30) which is connected to electric components (26, 19, 20, 34, 35) arranged on the rear side of the carrier plate (11), characterized in that the electroluminescent display (30) comprises an electroluminescent layer (12) which is applied together with an electrically conductive layer (15) to a common carrier layer (14) and in that the carrier layer (14) is led, with at least the electrically conductive layer (15) applied thereto, from the front side of the carrier plate (11) to the rear side of the carrier plate (11).

2. Indicating instrument according to Claim 1, characterized in that on the rear side the carrier plate (11) has conductor tracks which are fitted with the electric components (34, 35).

3. Indicating instrument according to Claim 1 or 2, characterized in that the electroluminescent display (30) is bonded onto the carrier plate (11).

4. Indicating instrument according to Claim 1 or 2, characterized in that the electroluminescent display (30) is printed onto the carrier plate (11).

5. Indicating instrument according to one of Claims 1 to 4, characterized in that the electroluminescent display (30) is connected to the components (26, 19, 20, 34, 35) via feed-through contacts and/or a contact element (32) running around an edge of the carrier plate (11).

6. Indicating instrument according to Claim 1, characterized in that the electrically conductive layer (15) on the rear side of the carrier plate (11) is fitted with electric components (26, 19, 20).

7. Indicating instrument according to one of Claims 1 to 6, characterized in that the carrier layer (14) with at least the electrically conductive layer (15) applied thereon is flexible.

8. Indicating instrument according to one of the preceding claims, characterized in that the carrier layer (14) is bonded onto the carrier plate (11).

9. Indicating instrument according to one of Claims 1 to 8, characterized in that the dial (13) is bonded onto the electroluminescent display (30).

## Revendications

1. Instrument indicateur, en particulier pour un véhicule automobile, comportant un cadran (13) éclairable, partiellement transparent, disposé sur la face avant d'une plaque support (11), de manière que, entre le cadran (13) et la plaque support (11), sur la plaque support (11) soit disposé un affichage électroluminescent (30) qui est relié à des composants électriques (26, 19, 20, 34, 35) disposés sur la face arrière de la plaque support (11),
caractérisé en ce que
• l'affichage électroluminescent (30) comprend une couche électroluminescente (12) qui, conjointement avec une couche conductrice d'électricité (15), est appliquée sur une couche support (14) commune, et
• la couche support (14), avec au moins la couche (15) conductrice d'électricité appliquée dessus, est guidée de la face avant de la plaque support (11) à la face arrière de la plaque support (11).

2. Instrument indicateur selon la revendication 1,
caractérisé en ce que
la plaque support (11) présente sur la face arrière des pistes conductrices, équipées des composants électriques (34, 35).

3. Instrument indicateur selon la revendication 1 ou 2,
caractérisé en ce que
l'affichage électroluminescent (30) est collé sur la plaque support (11).

4. Instrument indicateur selon la revendication 1 ou 2,
caractérisé en ce que
l'affichage électroluminescent (30) est imprimé sur la plaque support (11).

5. Instrument indicateur selon l'une des revendications 1 à 4,
caractérisé en ce que
l'affichage électroluminescent (30) est relié aux composants (26, 19, 20, 34, 35) par des contacts de passage et/ou un élément de contact (32) s'étendant autour d'un bord de la plaque support (11).

6. Instrument indicateur selon la revendication 1,
caractérisé en ce que
la couche (15) conductrice d'électricité située en face arrière de la plaque support (11) est dotée de composants électriques (26, 19, 20).

7. Instrument indicateur selon l'une des revendications 1 à 6,
caractérisé en ce que
la couche support (14), avec au moins la couche (15) conductrice d'électricité appliquée sur elle, est flexible.

8. Instrument indicateur selon l'une des revendications précédentes,
caractérisé en ce que
la couche support (14) est collée sur la plaque support (11) .

9. Instrument indicateur selon l'une des revendications 1 à 8,
caractérisé en ce que
le cadran (13) est collé sur l'affichage électroluminescent (30).
